Europäisches Patentamt

European Patent Office

Office européen des brevets

(11) Numéro de publication: **0 251 869**
**A1**

# (12) DEMANDE DE BREVET EUROPEEN

(21) Numéro de dépôt: **87401396.4**

(22) Date de dépôt: **19.06.87**

(51) Int. Cl.⁴: **H 01 R 4/18**
**H 01 R 23/68**

(30) Priorité: **24.06.86 FR 8609102**

(43) Date de publication de la demande:
**07.01.88 Bulletin 88/01**

(84) Etats contractants désignés:
**BE DE ES FR GB IT NL SE**

(71) Demandeur: **THOMSON-CSF**
**173, Boulevard Haussmann**
**F-75379 Paris Cédex 08 (FR)**

(72) Inventeur: **Le Parquier, Guy**
**Thompson-CSF SCPI 19, Avenue de Messine**
**F-75008 Paris (FR)**

(74) Mandataire: **Guérin, Michel et al**
**THOMSON-CSF SCPI 19, avenue de Messine**
**F-75008 Paris (FR)**

(54) **Connecteur pour connexion à plat.**

(57) L'invention concerne un connecteur pour connexion à plat apte à relier électriquement des pistes de circuits imprimés ou des pistes de circuit imprimé à un câble plat ou deux câbles plats entre eux, ce connecteur comprenant un manchon (10) en matériau à mémoire de forme dans lequel sont superposés les éléments conducteurs (20, 21) destinés à être en contact électrique, ce manchon (10) étant apte à appliquer des efforts transversaux sous l'effet d'une température prédéterminée de manière à ce qu'une continuité électrique puisse être assurée entre ces éléments (20, 21).

**FIG_1**

EP 0 251 869 A1

## Description

### CONNECTEUR POUR CONNEXION A PLAT

La présente invention concerne les connecteurs pour connexions à plat permettant notamment de relier électriquement un câble souple, plat, à un autre câble de même type ou à un circuit imprimé ou deux circuits imprimés entre eux.

On utilise généralement des connecteurs de forme allongée constitués en deux parties, une partie mâle et une partie femelle, chaque partie étant reliée à l'un des éléments à raccorder.

Il y a toujours des inconvénients d'ordre mécanique ou thermique avec ce type de connecteur. En effet lorsque les liaisons électriques sont réalisées par de tels connecteurs sur du matériel qui est destiné à être embarqué, par exemple en aéronautique, elles sont soumises à des conditions mécaniques ou thermiques très sévères qui peuvent les endommager. Par ailleurs, ces connecteurs ont toujours une force d'insertion et de désinsertion qui est non nulle, les montages et démontages répétitifs peuvent dégrader leurs propriétés mécaniques ou électriques.

D'autre part, il est connu d'utiliser des connecteurs à mémoire de forme constitués par une douille fendue préformée autour de laquelle est glissée une bague thermorétractable. Ce type de connecteur est particulièrement adapté à la connexion de circuits à broche. Chaque broche est insérée dans une telle douille et par chauffage (ou refroidissement) la force de rétreint de la bague devient supérieure à la force de rappel de la douille, les broches se trouvent donc pincées avec une forte pression de contact.

Cependant lorsqu'il s'agit de raccorder un câble plat souple à un autre câble plat souple ou à un circuit imprimé ou deux circuits imprimés entre eux, ce type de connexion présente l'inconvénient d'être encombrant et peu adapté à ces applications car les liaisons électriques ne se font pas par des broches mais par des fils ou des pistes.

La présente invention permet notamment de remédier à ces inconvénients et a pour objet un connecteur pour connexion à plat apte à relier électriquement des pistes de circuits imprimés ou des pistes à un câble plat ou deux câbles plats entre eux, ce connecteur étant principalement caractérisé en ce qu'il comporte un manchon en matériau à mémoire de forme dans lequel sont superposés les éléments conducteurs destinés à être en contact électrique, ce manchon étant apte à appliquer des efforts transversaux sous l'effet d'une température prédéterminée de manière à ce qu'une continuité électrique puisse être assurée entre ces éléments conducteurs.

La présente invention a également pour objet un connecteur dans lequel le manchon comporte deux faces parallèles aux plans dans lesquels se trouvent les éléments conducteurs, et deux côtés latéraux reliant ces faces, les faces étant susceptibles de se rapprocher l'une vers l'autre sous l'effet d'un changement de température et les bords latéraux étant susceptibles de se déformer par élasticité sous l'effet de ce même changement de température.

D'autres particularités de l'invention ressortiront de la description suivante faite à titre d'exemple non limitatif et qui est illustré par les dessins qui représentent :
- la figure 1, le schéma d'une coupe transversale d'un connecteur selon l'invention ce connecteur étant en phase de repos ;
- la figure 2, la même coupe selon la figure 1, le connecteur étant actif ;
- la figure 3, le schéma d'une coupe longitudinale d'un connecteur selon l'invention le connecteur étant en phase de repos ;
- la figure 4, la même coupe selon la figure 3, le connecteur étant en action ;
- la figure 5, le schéma d'une connexion entre un câble plat souple et un circuit imprimé selon l'invention.

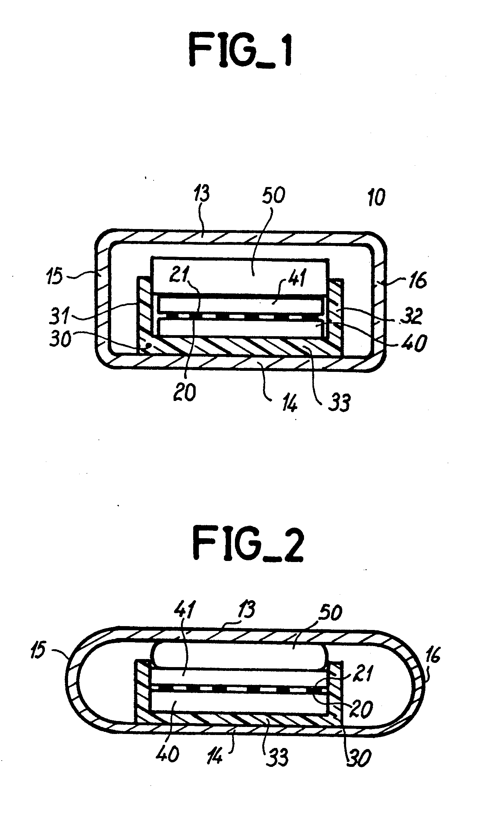

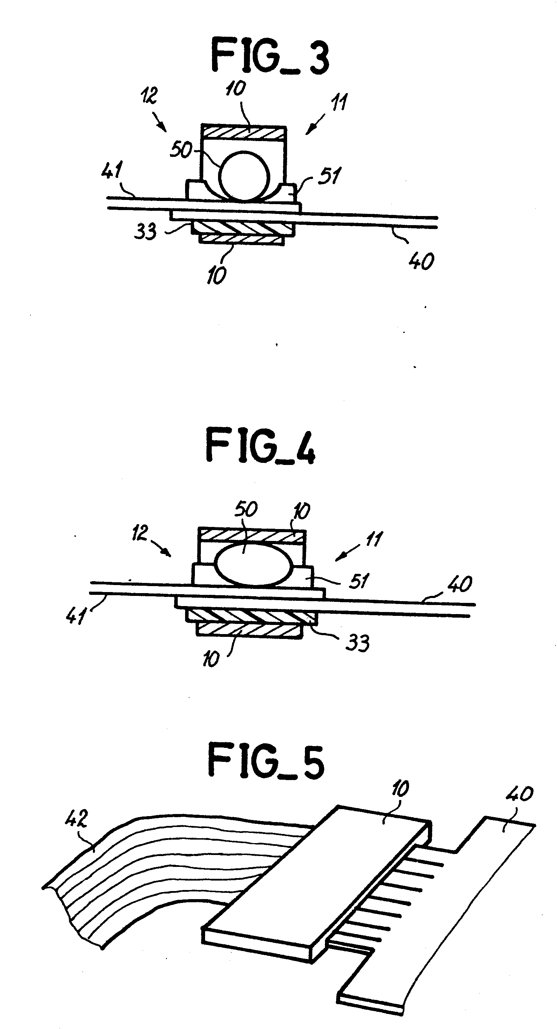

La figure 1 représente une coupe transversale d'un connecteur à plat selon l'invention. Ce connecteur comporte un manchon 10 en matériau à mémoire de forme dans lequel sont insérés des éléments conducteurs qui sont dans cet exemple particulier des pistes 20, 21, de deux circuits imprimés. Les pistes 20 et 21 sont placées en vis-àvis, les unes sur les autres. Elles sont guidées lors de la mise en place dans le manchon 10 par un guide 30 placé à l'intérieur du manchon. Les supports 40 et 41 des pistes sont insérés entre les parois 31 et 32 du guide, le support 40 portant les pistes 20 repose sur la paroi 33 formant le fond du guide 30. Le guide a la forme d'une auge dont les deux extrémités sont ouvertes. Au dessus du support 41 portant les pistes 21 est placé un joint 50 élastique, par exemple en élastomère, de forme par exemple cylindrique. Ce joint repose sur une cale 51 visible sous les figures 3 et 4. La cale 51 est placée entre les parois 31 et 32 du guide sur le support de piste 41.

L'axe longitudinal du joint se trouve perpendiculaire aux pistes. Le guide est solidaire du manchon par un adhésif par exemple de la colle. Le manchon a une forme par exemple parallélépipédique.

La connexion consiste en premier lieu à emboîter le manchon autour des pistes du support 40, puis à insérer le support 41 à l'intérieur du manchon dans le guide ces opérations étant effectuées à la température nécessaire pour que le manchon ait sa forme initiale dite de repos. La transformation de cette forme peut se faire soit à froid soit à chaud.

Selon cette réalisation particulière, la forme initiale de repos est obtenue à basse température (hors du domaine d'utilisation) par exemple sous jet de gaz carbonique ($CO_2$). Pendant le passage de cette température basse à la température ambiante d'utilisation le matériau à mémoire de forme s'aplatit comme on peut le voir sur la figure 2, de sorte que des efforts transversaux compriment les supports 40 et 41 l'un contre l'autre, piste contre piste.

Les deux faces 13 et 14 parallèles aux supports 40 et 41 s'aplatissent. Les côtés 15 et 16 subissent des efforts transversaux qui modifient leur forme. Le joint en élastomère 50 est comprimé et transmet les efforts aux supports. Il permet de répartir ces efforts sur toute la largeur du guide où se trouvent les pistes.

La nouvelle forme que prend le manchon est dite active. Le matériau utilisé par le manchon est par exemple un alliage à base de Nickel et de Titane.

Pour démonter le connecteur, il suffit de le refroidir au $CO_2$ pour que le manchon reprenne sa forme initiale.

Sur la figure 3, on a représenté le connecteur selon une coupe longitudinale. Les mêmes éléments portent les mêmes références. Sur cette figure 3 le connecteur est au repos. Après la mise en place du support des pistes 40 à travers l'ouverture 11 du manchon, le support de piste 41 est glissé sur le support 40 par l'ouverture 12 du manchon 10.

La figure 4, représente une coupe longitudinale du connecteur, dans sa phase active. Le joint 50 est écrasé et se déforme sous l'action du manchon 10. La gorge effectuée dans le câble 51 est prévue pour recevoir le joint déformé.

L'exemple de réalisation qui a été décrit correspond à la connexion de deux circuits imprimés. L'invention s'applique également à la connexion d'un câble plat souple 42 à un circuit imprimé 40 comme cela est représenté sur la figure 5. L'invention s'applique également à la connexion entre deux câbles plats souples.

## Revendications

1. Connecteur pour connexion à plat apte à relier électriquement des pistes de circuits imprimés ou des pistes de circuit imprimé à un câble plat ou deux câbles plats entre eux, caractérisé en ce qu'il comporte un manchon (10) en matériau à mémoire de forme à l'intérieur duquel sont mis en place les éléments conducteurs (20, 21) de manière à être superposés pour être en contact électrique, ce manchon (10) étant apte à appliquer des efforts transversaux sous l'effet d'une température prédéterminée de manière à ce qu'une continuité électrique puisse être assurée entre ces éléments (20, 21).

2. Connecteur selon la revendication 1, caractérisé en ce que le manchon (10) comporte deux faces (13, 14) parallèles aux plans dans lesquels se trouvent les éléments conducteurs (20, 21), et deux côtés latéraux (15, 16) reliant ces faces, les faces (13, 14) étant susceptibles de se rapprocher l'une vers l'autre sous l'effet d'un changement de température et les bords latéraux étant susceptibles de se déformer par élasticité sous l'effet de ce même changement de température.

3. Connecteur selon la revendication 1, caractérisé en ce que le manchon (10) présente deux ouvertures (11,12) par lesquelles pénètrent les supports (40, 41) des éléments conducteurs (20, 21) ces supports étant logés dans un guide (30) solidaire du manchon.

4. Connecteur selon la revendication 3, caractérisé en ce que le guide (30) est fixé par un adhésif au manchon (10).

5. Connecteur selon l'une quelconque des revendications 1 à 4, caractérisé en ce qu'il comporte un joint (50) élastique placé entre un support (41) d'éléments conducteurs (21) et une face (13) du manchon.

6. Connecteur selon la revendication 5, caractérisé en ce que le joint (50) est en joint cylindrique en élastomère.

7. Connecteur selon la revendication 5, caractérisé en ce que le joint (50) repose sur une cale (51) placée sur l'un des suports (41) des éléments conducteurs (21).

8. Connecteur selon l'une quelconque des revendications 1 à 7, caractérisé en ce que les éléments conducteurs (20, 21) sont des pistes de circuits imprimés et/ou des fils de câbles plats souples.

0251869

# FIG_1

# FIG_2

0251869

# FIG_3

# FIG_4

# FIG_5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl.4) |
|---|---|---|---|
| A | WO-A-8 505 500 (KRUMME) <br> * En entier * | 1,2,8 | H 01 R 4/18 <br> H 01 R 23/68 |

-----

DOMAINES TECHNIQUES RECHERCHES (Int. Cl.4)

H 01 R 4/00
H 01 R 13/00
H 01 R 9/00
H 01 R 23/00

Le présent rapport de recherche a été établi pour toutes les revendications

| Lieu de la recherche | Date d'achèvement de la recherche | Examinateur |
|---|---|---|
| LA HAYE | 01-10-1987 | RIEUTORT A.S. |